# EUROPEAN PATENT APPLICATION

(11) **EP 4 819 767 A1**
(43) Date of publication of application: **07.10.2026**
(21) Application number: 26162303.7
(22) Date of filing: 04.03.2026
(51) Int. Cl.: H05K 1/02, H05K 3/42, H05K 3/00

(54) **A COMPONENT CARRIER**

(30) Priority: 31.03.2025 CN 202510396803
(71) Applicant: AT&S (Chongqing) Company Limited, Chongqing 401133 (CN)
(72) Inventor: CHIU, Fanyi (Michael), 235 New Taipei City (TW); WANG, Raymond, Chongqing, 401331 (CN); ZENG, Tiki, Zhoujiawan Village, 413400 (CN); ZHOU, Rachel, Chongqing, 401133 (CN)
(74) Representative: Donatello, Daniele

(57) **Abstract**

The invention relates to a component carrier (1), comprising a stack (2) comprising at least one conductive layer structure (3) and at least one insulating layer structure (4), wherein the at least one insulating layer structure (4) comprises a through opening (5) that is filled with a conductive material (6) of the at least one electrically conductive layer structure (3). Said at least one electrically conductive layer structure (3) is in contact with a first main surface (7) of said at least one insulating layer structure (4), wherein the at least one electrically conductive layer structure (3) comprises a protruding portion (8) at the through opening (5) that is protruding from a surface of the at least one electrically conductive layer structure (3), away from the first main surface (7) of said at least one insulating layer structure (4)

## Description

The invention relates to a component carrier comprising a stack of a plurality of layers forming at least one electrically conductive layer structure and at least one electrically insulating layer structure. The invention also relates to a method for manufacturing a component carrier.

In the context of growing product functionalities of component carriers equipped with one or more electronic components and increasing miniaturization of such components as well as a rising number of components to be mounted on or embedded in the component carriers such as printed circuit boards, increasingly more powerful array-like components or packages having several components are being employed, which have a plurality of contacts or connections, with ever smaller spacing between these contacts. Removal of heat generated by such components and the component carrier itself during operation becomes an increasing issue. At the same time, component carriers shall be mechanically robust and electrically reliable so as to be operable even under harsh conditions.

A trench or a plurality of trenches can often be used for thermal dissipation. The trench(es) may have a large lateral extension for this purpose (or also further purposes) which is at least partially filled with conductive material (such as copper) for better thermal dissipation performance, for example from upper side to the bottom side of the trench(es). A further problem with regard to this case is that a trench comprises a large dimple in the surface of the trench(es) caused by the relatively large lateral extension of the trench(es) compared with conventional opening structures such as via, through hole, so that the flatness is mainly corrugated by mechanical post processing.

The TW410453 B discloses a double-plated process to fill the recess in an insulating layer while avoid a dishing during the subsequence grinding process. A leveler is added in a second plating process to reduce the copper growth rate of the second-plated copper at the edge and protrusions of the first-plated copper.

The EP0817549 A2 discloses a circuit board comprising a lower insulation layer and a side insulation layer formed on an upper surface of said lower insulation layer and having a pair of layer sections, wherein a conductor wiring layer formed on the upper surface of said lower insulation layer having opposite side surfaces in contact with said layer sections of said side insulation layer, respectively and wherein catalytic nuclei for plating are provided to an interface between a bottom surface of said conductor wiring layer and the upper surface of said lower insulation layer and to an interface between each of said side surfaces of said conductor wiring layer and a corresponding side surface of each of said layer sections of said side insulation layer.

A disadvantage of the component carriers according to the prior art, is that the filled openings often do not have optimal properties with regard to their conductive material, so that they are of reduced quality or deviate from a tolerance with regard to their intended function. Another disadvantage of the prior art is that an extra process, for example polishing, or also additional material, like a leveler is often needed to reduce the dimple. The polishing process may further cause a higher risk of warpage.

It has been the object of the present invention to overcome the disadvantages of the prior art and to provide a component carrier and method by means of which a quality and structure of the conductive material that is provided in the openings can be improved.

This object is achieved by a component carrier, comprising
- a stack comprising at least one conductive layer structure and at least one insulating layer structure, wherein the at least one insulating layer structure comprises a through opening that is filled with a conductive material of the at least one electrically conductive layer structure, wherein said at least one electrically conductive layer structure is in contact with a first main surface of said at least one insulating layer structure, and wherein the at least one electrically conductive layer structure comprises a protruding portion at the through opening that is protruding from a surface of the at least one electrically conductive layer structure away from the first main surface of said at least one insulating layer structure.

The invention also comprises a method for manufacturing a component carrier as already mentioned, comprising the steps of:
- providing a stack comprising at least one insulating layer structure and at least one conductive layer structure,
- forming at least one through opening in the insulating layer structure;
- filling the through opening with a conductive material of the at least one electrically conductive layer structure;
wherein a protruding portion is formed at the through opening, and wherein the protruding portion protrudes from a surface of the further conductive layer structure away from a first main surface of said at least one insulating layer structure.

The protruding portion can be obtained by an additional plating step. For example, the filling of the through opening can be provided by a first plating step and the protruding portion by a second plating step.

Therefore, the amount of conductive material in the through opening can be increased.

The invention has the advantage, that a flat surface of the conductive layer structure can be provided in (and/or above) the through opening; wherein the conductive material filling the through opening comprise improved characteristics, in particular with respect to its electrical conductivity and thermal conductivity. Furthermore, the process of manufacturing the conductive layer structure may also be simplified.

For example, a higher density of the conductive material can be provided for a trench or a via by means of the invention. Preferably, the higher density can result in an improved current supply or heat transfer for thermal dissipation. As mentioned before, this can be crucial for the increasing product functionalities; for example, for high-power and high-frequency applications.

By providing the protruding portion, a mechanical post-processing step - for example polishing - of the conductive material in the area of the through opening may also be skipped or avoided, so that a high surface quality of the conductive layer can be provided without the need of further steps.

Especially if mechanical post-processing, like polishing can be omitted, a higher roughness can be provided for the remaining surface of the conductive material. The higher roughness can result in an improved adhesion between the layers, as well as between conductive layers and between conductive layers and insulating layers.

A further advantage of omitting the mechanical post-processing can be the reduction of warpage.

A further advantage of the invention is that the protruding portion can provide an improved surface above the insulating layer structure which serves to enhance the bonding of conductive material of an additional layer structure provided above the protruding portion.

The invention also solves the problem of the prior concerning the flatness of a trench with a large lateral extension.

According to a preferred embodiment, the protruding portion may comprise an additional layer of conductive material on the electrically conductive layer structure.

Generally, the amount of conductive layers composing the at least one electrically conductive layer structure at the first main surface of said at least one insulating layer structure may be preferably lower than the amount of layers of the at least one electrically conductive layer structure at the protruding portion. This feature can also provide a footprint of the invention, as described before, for example a second plating step.

According to a further embodiment, the surface of the conductive material on the first main surface of the component carrier may be in a ratio of more than 20% of the surface area of said first main surface of the component carrier. For example, a via and/or a trench may be formed in the electrically insulating layer structure of the component carrier, preferably having a surface of conductive material of more than 20% of the surface area of said first main surface of the component carrier. The high surface ratio may be resulted from the additional layer of conductive material at the protruding portion, due to the second plating process. The high surface ratio of conductive material in general may relate to an improved current capability. The high surface ratio of conductive material may also refer to a better heat transfer coefficient.

The protruding portion may be delimited by an etched portion of the at least one conductive layer structure. This may provide a further footprint of the invention, by etching the plated conductive layer. Furthermore, the mechanical post-processing can be omitted, in order to achieve the advantages as described before.

According to one embodiment, the conductive material filling the through opening may have a grain size in its core area higher than a grain size of a respective lateral portion of the conductive material filling the through opening.

For example, when using DC-plating step, in order to fill the internal area of the through opening, the structure may result in coarser grains, with respect to a pulse plating to form the external-peripheral layers, which may result in finer grains.

As core area of the conductive material it is meant the area, along the cross section of the opening, that is at least partially, in particular mainly, delimited by the conductive layer(s) provided on the lateral wall(s) of the opening; in other word, along the cross section of the opening, it consists of the volume of conductive material delimited by the conductive shielding covering the opening.

A lateral portion of the conductive layer structure may comprise at least one layer(s) in contact with a lateral surface of the through opening. A part of the conductive layer structure may extend into the through opening and may be in direct contact with the lateral surface (lateral wall) of the through opening. This feature may also provide a better adhesion of the conducive layer structure in the through opening.

Preferably the lateral portion of the conductive layer structure may comprise at least one layer that defines the protruding portion. The at least one layer or a plurality of layers comprising the lateral portion of the conductive material may also compose the protruding portion. For example, they may be plated at the same time, as described before, by a first plating step and then by at least one (further) second plating step.

According to a further embodiment, at least one step may be formed by the protruding portion. The step may be formed by carrying out a (flash) etching process and/or a plating process. The step may enhance the connection strength between the protruding portion and a conductive material filled in further through opening due to its enlarged contact area and its high(er) roughness.

The step may be achieved by a multiple plating step. A temporary layer, for example a dry film, can be provided to form the step in an exposure and developing manufacturing process. Therefore, openings may be formed in layers of the dry film in such a way that they do not align with each other, with respect to each of the plating steps. As a result, the step of the conductive material can be formed due to an offset (of the openings) of the dry films.

The step is further footprint of the process, which can be seen in a cross section of the stack.

The step may be formed by a circumferential step that can define the protruding portion, preferably from a plane view.

According to a further embodiment, an irregular formed side of the conductive layer structure may define the step. The irregular formed side may be provided along a direction that can be not linear, preferably along a non-fixed path in a cross section. A further advantage is that the step can be obtained in an easy way, for example, without having a very dedicated profile.

The step may comprise a straight side being perpendicular to the first main surface. In another embodiment, the step may comprise an inclined side with respect to the first main surface. The inclination can also be formed in such a way that the step is tapered in the direction away from the first main surface. As a consequence, the dimension of the lower portion of the step (which is closer to the first main surface) may be larger than the dimension of the upper portion.

In one preferred embodiment, the protruding portion may at least partially overlaps a profile of the through opening in a planar direction, in particular completely. The complete overlap of the protruding portion in a planar direction can result in a dense arrangement of the conductive material at the through opening/protruding portion, preferably to improve the adhesion and the thermal dissipation effect.

The protruding portion may be formed in an offset from the through opening in a planar view. In other words, the vertical center axis of the protruding portion may be shifted with respect to the vertical center axis of the through opening. This feature may also improve the adhesion and the thermal dissipation effect.

According to a preferred embodiment, the protruding portion may comprise a dimple, wherein the dimple extends inside said protruding portion. Furthermore, the dimple may be formed planarly within an extension of the protruding portion. The dimple may also be formed planarly inside an extension of the through opening. The dimple may have a depth from 1µm to 20 µm, preferably 5µm - 10µm. The dimple can result in in a greater contact surface, preferably in order to achieve a better adhesion.

According to one embodiment, the through opening may be formed by a trench. Preferably, the trench may comprise a tapering sidewall. The tapering sidewall may be arranged circumferentially. The tapering sidewall may be formed by a laser process, preferably by a cut-out.

The trench may be formed planarly in an elongated direction with respect to the first main surface. The elongated direction may be preferably an extension direction planar through the stack, wherein the extension of the trench can extend up between a length or width of the component carrier with respect to a top view. A trench in an elongated direction may increase the surface area and/or a volume of the conductive material, preferably in order to improve the thermal dissipation efficiency and/or power/ground supply (e.g. allows a higher current flow).

A further embodiment may comprise a plurality of trenches that may be formed in a plane parallel to the first main surface with respect to each of the trenches. The plurality of trenches may result in an improved distribution of properties in a horizontal direction. Preferably the stiffness of the whole board can be improved.

A size of the trench or at least one trench of the plurality of trenches (e.g. to ensure a proper heat transfer from or to a surface mounted or embedded component) may be adapted to provide a heat transfer by the trench, preferably from a top of the trench to a bottom of the trench For example; the heat transfer from a substrate above to a main board below may be enhanced by this feature.

Preferably, a part of the electrically conductive structure that forms the protruding portion may be disconnected from a remaining electrically conductive layer structure at the first main surface of said at least one insulating layer structure. This embodiment provides the advantage, that the conductive layer structure at the protruding portion may be designed especially for thermal dissipation.

For the sake of completeness, it should be mentioned that the conductive structure forming the protruding portion may also be connected to the remaining electrically conductive layer structure, as example, for signal transfer, power supply or ground supply.

According to a preferred embodiment, the conductive material filling the through opening may have a grain size in its core area higher than a grain size of the remaining electrically conductive layer structure. The different grain size may be provided by the first and at least second plating step, as described before. Preferably, the different grain size may be provided by the lateral portion (as described before) and the conductive material filling the through opening.

Furthermore, the part of the electrically conductive structure at the protruding portion that is disconnected from the remaining electrically conductive layer structure may be provided for thermal dissipation in the stack. According to a possible embodiment, the part may be only provided for thermal dissipation.

Furthermore, the copper density in the volume of the component carrier comprising said (disconnected) part of the electrically conductive structure at the protruding portion may be higher than the copper density in the volume of the component carrier comprising said remaining electrically conductive structure at the protruding portion. This may also result in an improved thermal dissipation.

According to one preferred embodiment, a second electrically conductive layer structure may be provided on an opposed second main surface of the insulating layer structure, wherein said conductive material on the first main surface of said at least one insulating layer structure and in the through opening may be connected to said second electrically conductive layer structure to form a boundary connecting area. Thereby, a better conductive/mechanical connection can be formed that enables an uninterrupted thermal conductive path between different layers in the stack.

Said boundary connecting area may have a concave shape defining a dimple in the second electrically conductive layer structure. Preferably the protruding portion and the concave-shaped dimple at least partially overlap one to each other in a planar view or in a vertical direction. The dimple (of the boundary connecting area) may provide a further footprint. It can be formed by a similar structure at the area of the second main surface, for example by a further through opening and a further protruding portion, arranged below the actual through opening.

The boundary connecting area may result in a larger contact surface, as well as in better adhesion properties.

In one embodiment, a further insulating layer structure may be provided, preferably laminated, on a main surface of the at least one conductive layer structure and on the first main surface of said at least one insulating layer structure, said further insulating layer structure may comprise a further through opening filled with a conductive material. Furthermore, the conductive material filled in the further through opening may be in contact with the protruding portion. Improved properties of the stack can be provided by this feature with regard to the thermal dissipation.

According to one embodiment, at least one further step portion may be formed at a lateral edge of the further insulating layer structure and wherein the at least one further step portion may be complementary with the step of the protruding portion. The step and the further step may be designed mirrored with respect to each other. Preferably, the step of the insulating layer structure can be complementary with the step of the protruding portion. This feature may result in an improved adhesion between the layers.

At least one further electrically conductive layer structure may be in contact with the second main surface of said further insulating layer structure, and may comprise a further protruding portion at the further through opening area, wherein the further protruding portion protrudes from a surface of the further conductive layer structure away from the second main surface of said further insulating layer structure. This feature can improve the provision of the conductive material through the stack, preferably in order to enhance the thermal dissipation.

According to one embodiment, each of the through opening and at least the further through opening may each be formed by one of at least two trenches, wherein the at least two trenches (in a stack form) may be filled with conductive material of the conductive layer structures. A better thermal dissipation efficiency and/or an improved power/ground supply may be achieved by this feature.

The invention also comprise a method for manufacturing a component carrier as already mentioned, comprising the steps of:
- providing a stack comprising at least one insulating layer structure and at least one conductive layer structure,
- forming at least one through opening in the insulating layer structure;
- filling the through opening with a conductive material of the at least one electrically conductive layer structure;
wherein a protruding portion is formed at the through opening, and wherein the protruding portion protrudes (from a surface) of the further conductive layer structure away from a first main surface of said at least one insulating layer structure.

Preferably, the protruding portion may be formed by plating an additional layer of conductive material on the electrically conductive layer structure. Preferably, a dimple of the electrically conductive layer structure can be covered by the addition conductive material, and the dimple may be decreased with respect to its depth.

Furthermore, the protruding portion may be formed by etching a portion of the at least one conductive layer structure in order to delimit the protruding portion in a highly efficient manner.

As mentioned before, the protruding portion may be provided by forming a step in the conductive layer structure. The step may be formed by flash etching the conductive layer structure, preferably after applying and stripping a dry film.

According to a preferred embodiment, a dimple may be formed in the protruding portion, wherein the dimple extends inside the protruding portion. Preferably the dimple may be formed by a plating step at the through opening. The plating step in the through opening can result in a large dimple, mitigated by the plated portion forming the protruding portion, which may result in a smaller dimple (with respect to its depth).

In general, the dimple itself may be obtained by the volume of the conductive material filled in the through opening, in relation to the volume defined by the through opening.

According to a possible embodiment, the through opening may be provided by forming a trench in the insulating layer structure. As mentioned before, the trench may provide a greater volume of conductive material, preferably for thermal dissipation.

The trench may by formed by a laser, for example a CO₂ laser. This feature provides an efficient process to form the trench.

Preferably a plurality of trenches may be formed in a planar direction with respect to each of the trenches. The plurality of trenches may result in an improved distribution of properties in a horizontal direction. Preferably the stiffness of the whole board can be improved.

The method for manufacturing a component carrier may also comprise a step of providing a second electrically conductive layer structure on the opposed second main surface of the insulating layer structure, wherein the conductive material on the first main surface of said at least one insulating layer structure and in the through opening may be connected to said second electrically conductive layer structure to form a boundary connecting area. The concave shape can provide a footprint of a desmearing of the though opening before plating inside the opening. A better conductive/mechanical connection can be formed that enables an uninterrupted thermal conductive path between different layers in the stack.

Preferably said boundary connecting area may be formed in a concave shape in such way that a dimple is provided in the second electrically conductive layer structure. This feature may result in a larger contact surface.

A possible further step may be intended of providing a further insulating layer structure on a planar surface of the at least one conductive layer structure and on the first main surface of said at least one insulating layer structure, wherein a further through opening may be formed in said further insulating layer structure and wherein the further through opening may be filled with a conductive material. By this feature, improved thermal dissipation of the stack can be achieved.

The conductive material filled in the further through opening may contact the protruding portion. As mentioned before, the thermal dissipation and/or the adhesion can be improved.

According to a further possible embodiment at least one further electrically conductive layer structure may be provided on a further main surface of said further insulating layer structure, wherein a further protruding portion may be formed at the further through opening area protruding away from the further main surface of said further insulating layer structure. An arrangement of conductive material through the stack can be increased by this feature, preferably in order to enhance the thermal dissipation

According to a further embodiment, each of the through opening and at least the further through opening may be formed by a trench, wherein the through opening and at least the further through opening may be filled by conductive material in each step of providing the electrically conductive layer structure and providing the further conductive layer structure. A better thermal dissipation efficiency can be achieved by this feature. A repetition of this process may be carried out, extended to an individual thickness of the through opening(s) according to any specific requirement of thermal dissipation and/or conductive material provided in the through opening(s).

The method may further comprise at least one step of providing at least one temporary layer. The temporary layer may have at least one opening or breakthrough. The temporary layer can be used in a step of partially removing a part of the conductive layer structure, preferably by etching. A temporary layer may also be used for partially applying a conductive material on the conductive layer structure.

The temporary layer may comprise a dry film, which can be developed by optical or mechanical means.

It is understood that a "material" in the sense of the present application may comprise one or more type(s) of element(s). It is further understood, that even if two of the (first, second and third) materials comprise the same element, but differ in another element and/or in composition and/or in element ratio, they are considered as being different from each other. For example, if the first material is a TiW alloy and second material is Ti, they are of course different to each other.

In the context of the present application, the term "component carrier assembly" is understood as a combination of a component carrier and at least one electronic component.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote an arrangement of multiple planar layer structures which are mounted in parallel on top of one another. It may comprise at least one electrically insulating layer structure and at least one electrically conductive layer structure. For example, the stack may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high-density product. The stacking direction (height/thickness) may be arranged in the vertical direction z. Further, the stacking direction may be perpendicular to the two directions of main extension (along x and y) of the (plate-shaped) component carrier.

In the context of the present application, the term "layer structure" may particularly denote a continuous or discontinuous layer, a patterned layer or a plurality of non-consecutive islands within a common plane. A plurality of such layers, parallel stacked one upon the other, may form the stack in the vertical direction.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

Preferably, the component carrier assembly is a printed circuit board (PCB) and/or a substrate (such as an IC substrate) and/or an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the at least one electrically insulating layer structure comprises at least one of the group, consisting of a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins is called prepreg. These prepregs are often named after their properties for example FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

According to a further possible embodiment, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

To provide better understanding of the invention, the invention is explained in more detail with the aid of the following figures.

The following is shown in a strongly simplified, schematic representation:
- Fig. 1: a first embodiment of a component carrier;
- Fig. 2: a detail of an embodiment of a component carrier;
- Fig. 3: a first embodiment of an intermediate product;
- Fig. 4: a second embodiment of an intermediate product;
- Fig. 5: a third embodiment of an intermediate product;
- Fig. 6: a top view of a possible embodiment of a plurality of trenches.

As an introduction, it should be noted that in the embodiments described in different ways, identical parts or method steps are indicated with identical reference numbers or identical component designations; at the same time, the disclosures contained in the entire description may be analogously applied to identical parts with identical reference numbers or identical component designations. Moreover, the position indications chosen in the description, such as at the top, at the bottom, laterally, etc. refer to the figure which is directly represented and described; and if a position changes, said position indications are to be applied analogously to the new position.

For the sake of good order, it should finally be noted that, for better understanding, some of the facts shown in the figures have been represented unscaled and/or enlarged and/or in reduced size.

Fig .1 shows a first embodiment of a component carrier 1, comprising a stack 2 comprising at least one conductive layer structure 3 and at least one insulating layer structure 4, wherein the at least one insulating layer structure 4 comprises a through opening 5 that is filled with a conductive material 6 of the at least one electrically conductive layer structure 3, wherein said at least one electrically conductive layer structure 3 is in contact with a first main surface 7 of said at least one insulating layer structure 4, and wherein the at least one electrically conductive layer structure 3 comprises a protruding portion 8 at the through opening 5 that is protruding from a surface of the at least one electrically conductive layer structure 3 away from the first main surface 7 of said at least one insulating layer structure 4.

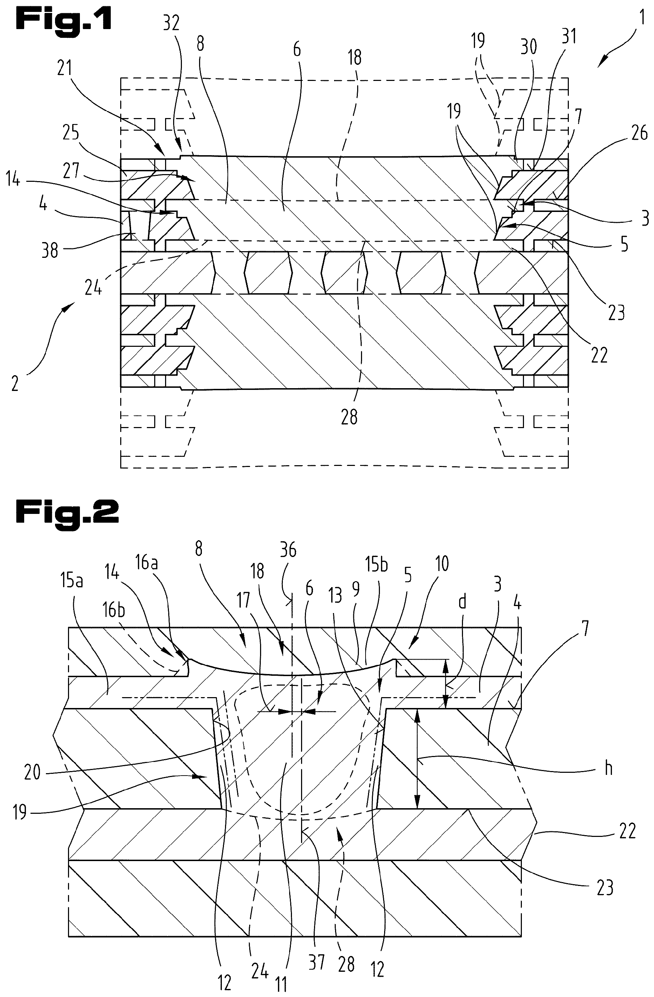

As shown in Fig. 1 the stack may comprise a center structure, preferably with a core (layer) (e.g. a cured reinforced resin such as FR4) to provide mechanical support and electrical insulation. Alternatively, the center structure of the stack may comprise a coreless structure, for the applications which need more flexibility and bendability, for example prepreg.

The at least one conductive layer structure 3 and at least one insulating layer structure 4 may be provided on the center structure. The conductive layer structure 3 on a first side of the center structure may be connected with a respective conductive structure on an opposed second side of the center structure by at least one through holes/vias filled with conductive materials in the center structure. A schematic via 38 is indicated in Fig. 1.

In general, the component carrier may have further similar layer structures at its second side as shown in Fig. 1. The layer structures on the second side may further be mirrored with respect to the first side. Alternatively, the layer structures on the second side of the stack may be different and/or arranged in offset to the first side with respect to a vertical plane.

Furthermore, independent of the embodiment shown, the conductive layer structure may comprise at least one via and/or at least one trench.

A part 21 of the electrically conductive structure 3 that forms the protruding portion 8 may be electrically and/or physically disconnected from a remaining electrically conductive layer structure 3 at the first main surface 7 of said at least one insulating layer structure 4.

For instance, the protruding portion 8 can be defined in a way that an insulting structure, which serve as an intermediate connection in between two (vertically) adjacent insulting layers of the insulating layer structure 4 in the stack 2 separates/insulates the protruding portion 8 from the remaining electrically conductive layer structure, thus a specific function can be realized.

Independent of the embodiment shown; with respect to the term "remaining electrically conductive layer structure 3" , it should be mentioned that those areas of the electrically conductive structure are referring to the electrically conductive structure which do not comprise the portion that is filled in the through opening, as well as the protruding portion 8 and its extension on the first main surface 7 of the at least one insulating layer structure 4.

The part 21 of the electrically conductive structure at the protruding portion 8 that is disconnected from the remaining electrically conductive layer structure 3 may be provided for thermal dissipation in the stack 2.

Preferably, the conductive material 6 filling the through opening 5 may have a grain size in its core area 11 (see Fig. 2) which is higher than a grain size of the remaining electrically conductive layer structure 3. The core area 11 may be formed by the use of a DC plating to fill the internal of the opening (resulting in coarser grains) with respect to a pulse plating to form the remaining electrically conductive layer structure 3 (resulting in finer grains)

A density of the conductive material in the volume of the component carrier 1 comprising said (disconnected) part 21 of the electrically conductive structure 3 at the protruding portion 8 may be higher than the density of the conductive material in the volume of the component carrier 1 comprising said remaining electrically conductive structure at the protruding portion 8. Preferably the (disconnected) part 21 does not affect other "active" conductive material of the remaining electrically conductive layer structure in a conductive manner.

With respect to this feature a different density (preferably higher), can be achieved, as well as larger areas of conductive material.

According to another possible embodiment, a further electrically conductive layer structure 22 may be provided on an opposed second main surface 23 of the insulating layer structure 4, wherein said conductive material 6 on the first main surface 7 of said at least one insulating layer structure 4 and in the through opening 5 may be connected to said further electrically conductive layer structure 22 to form a boundary connecting area 24. Thereby a better conductive/mechanical connection is formed enabling an uninterrupted thermal conductive path between different layers in the stack 2.

Said boundary connecting area 24 may have a concave shape defining a further dimple 28 in the further electrically conductive layer structure 22. In particular, the depth of the dimple size at a range between 1µm to 20µm, preferably 5µm to 10µm

According to a preferred embodiment, the protruding portion 8 and the concave-shaped dimple 28 may overlap one to each other in a planar view, preferably along a vertical direction.

Moreover, a further insulating layer structure 25 may be laminated on a planar surface 26 of the at least one conductive layer structure 3 and on a the first main surface 7 of said at least one insulating layer structure 4, said further insulating layer structure 25 may comprise a further through opening 27 filled with a conductive material 6.

Preferably the conductive material 6 filled in the further through opening 27 may be in contact with the upper main surface of the protruding portion 8. Thereby a better conductive/mechanical connection between two (build up) layers is formed enabling an uninterrupted/constant thermal conductive path between different layers in the stack 2.

According to a preferred embodiment, each of at least two openings comprising a first through opening 5 and at least a further through opening 27 may be formed by one of at least two trenches 19, wherein the at least two trenches 19 may be filled with conductive material 6 of the conductive layer structures 3, 30.

According to one embodiment, the at least one further electrically conductive layer structure 30 may be in contact with the further main surface 31 of said further insulating layer structure 25, and may comprise a further protruding portion 32 at the area of the further through opening 27, wherein the further protruding portion 32 protrudes from a surface of the further conductive layer structure 30 away from the further main surface 31 of said further insulating layer structure 25.

Preferably, several plating steps may be performed of providing the electrically conductive layer structure 3 and a further providing the further conductive layer structure in order to achieve a stack-filling of multiple trenches.

As indicated further indicated by dashed lines in Fig. 1, the stack 2 may comprise further insulating layer structures with further through openings that may be filled with conductive materials, preferably formed by trenches 19.

A size of at least one trench 19, preferably a size of each of the multiple trenches, may be adapted to provide a heat transfer of the trench in particular from a top of the trench to the bottom of the trench (in a vertical direction). In particular, the trench has a large area in lateral direction, an effectiveness of heat transfer thereby enhanced. In a case that a heating component is able to connect or thermally couple with the trench (filled with conductive materials, e.g. thermal conductive materials) to achieve an effective heat dissipation.

Fig. 2 shows a detail of a through opening 5 of a possible embodiment of a component carrier, in a cross-sectional view, wherein equal reference numbers/component designations are used for equal parts as before in Fig.1. In order to avoid unnecessary repetitions, it is pointed to/reference is made to the detailed description in Fig. 1.

The protruding portion 8 may comprise an additional layer 9 of conductive material 6 on the electrically conductive layer structure 3 by conducting a second plating.

In general, the amount of conductive layers 15a composing the at least one electrically conductive layer structure 3 at the first main surface 7 of said at least one insulating layer structure 4 may be lower than the amount of conductive layers 15b of the at least one electrically conductive layer structure 3 at the protruding portion 8. This feature may be achieved by a plating process, as mentioned before, preferably by plating at least one second plating on a first plating, in order to provide the conductive layers at the protruding portion.

Independent of the embodiment shown, the surface of the conductive material 6 on the first main surface 7 of the component carrier 1 may be in a ratio of more than 20% of the surface area of said first main surface 7 of the component carrier 1. Preferably the surface area of the conductive material 6 that is filled in the area of the through opening 5 and the vias may be at least 20% with respect to the surface area of the main surface of the (whole) component carrier 1. The high surface ratio may be resulted from the additional layer 9 of conductive material 6 at the protruding portion 8, due to the second plating process.

According to one embodiment, the protruding portion 8 may be delimited by an etched portion 10 or plated portion of the at least one conductive layer structure 3, depending on the process, for example, an mSAP process or alternatively, a subtractive process.

The conductive material 6 that fills the through opening 5 can also have a grain size in its core area 11 higher than a grain size of a respective lateral portion 12 of the conductive material 6 filling the through opening 5. The core area 11 may be formed by the use of a DC plating to fill the internal of the opening (preferably resulting in coarser grains). A pulse plating may be used to form the respective lateral portion 12 (preferably resulting in finer grains). In another case, the current density at the core area 11 may be lower (preferably resulting in coarser grains), while the current density on a respective lateral portion 12 is relatively higher (resulting in finer grains).

A part of the lateral portion may be formed by a conductive layer which can be applied in a first step, for example, a seed layer.

Independent of the embodiment shown, a lateral portion 12 of the conductive layer structure 3 may comprise at least one layer or several layers in contact with a lateral surface 13 of the through opening 5. The lateral portion 12 of the conductive layer structure 3 may comprise layers that are defining the protruding portion 8.

As indicated by centered line, the layer(s) of the conductive layer structure forming the lateral portion 12 may extend on the first main surface 7 of the insulating layer structure 4 which helps to define (a clear edge of) the protruding portion 8. Therefore the edge or step 14 of the protruding portion 8 can be recognized in the final component carrier.

For example, the lateral portion 12 may be provided by a plating step, wherein the same layer that forms the lateral portion 12 can also be provided in the area of the protruding portion as well as on the first main surface 7. The shape of the protruding portion may also be formed at least partially by plating layer with respect to the contour provided by the lateral portions.

Preferably, at least one step 14 may be formed by the protruding portion 8. In one embodiment, the step 14 may be formed by a circumferential step that defines the protruding portion 8. In a case, the step 14 formed by conducting a (flash) etching process and/or a plating process. The step 14 may enhance the connection strength between the protruding portion 8 and a conductive material 6 filled in further through opening 27 due to its enlarged contact area and high roughness.

Furthermore, an irregular formed side 16a of the conductive layer structure 3 defines the step 14. The term "irregular formed side" may refer to a not linear extension or an extension that is arranged in a non-planar direction.

The irregular formed side may comprise further possible geometries, independent of the embodiment shown; as a rounded shape for example concave or convex, multiple steps.

The step 14 may comprise straight side being perpendicular to the first main surface 7. The step may further comprise an inclined side 16b with respect to the first main surface 7. The inclination can be formed in such a way that the step 14 is tapered in the direction away from the first main surface 7. That is to say, the dimension of the lower portion of the step 14 (which is closer to the first main surface 7) can be larger than the dimension of the upper portion.

The protruding portion 8 may least partially overlap the through opening 5 in a plane direction, in particular completely, preferably including the lateral extension of the step.

The protruding portion 8 can preferably be formed in an offset 17 from the through opening 5 in a planar view. In other words, a first vertical center axis 36 of the protruding portion 8 is shifted with respect to a second vertical center axis 37 of the through opening 5.

According to a preferred embodiment, the protruding portion 8 may comprise a dimple 18, wherein the dimple 18 extends inside said protruding portion 8. The dimple 18 may be formed planarly within an extension of the protruding portion 8.

Independent of the embodiment shown, dimple according to the invention may have a depth of 1µm to 20µm, preferably 5µm to 10µm with respect to an extension of the protruding portion 8.

The dimple 18 may also be formed planarly inside an extension of the through opening 5.

An upper end of the protruding portion may comprise the edge of the dimple, which may be arranged inside a lateral extension of the protruding portion and/or the through opening, as it can be seen in Fig. 2.

The dimple 18 can be formed in the additional layer 9 of the protruding portion 8.

Independent of the embodiment shown, the through opening 5 is formed by a trench 19. In a further possible embodiment, the trench 19 may comprise a tapering sidewall 20 formed by a laser drilling.

The trench 19 may be formed planarly in an elongated direction with respect to the first main surface 7. For example, the through opening may have a straight side wall. The side wall can be formed by a laser, for example.

Independent of the embodiments shown, the trench can also be formed discontinuously along the elongated direction,

According to a further possible embodiment, a plurality of trenches 19 may be formed in a plane parallel to the first main surface 7 with respect to each of the trenches. A possible arrangement of a plurality of trenches will be described later.

A size of the trench 19, may be adapted to provide a heat transfer by the trench 19, preferably in order to ensure a proper heat transfer from or to a surface-mounted or embedded component, in particular from a top of the trench to the bottom of the trench. Preferably the heat transfer coefficient of the adapted trench may be increased by a factor of 1,5 to 2, compared to conventional electrically conductive layer structures (e.g., vias, trace, block) that is provided in the stack for thermal dissipation purposes.

A heat transfer coefficient of a normal trench may be between 70-100 W/mK, wherein the adapted (high density) trench 19 may have a heat transfer coefficient of about 180 W/mK to 220 W/m²K.

Independent of the embodiment shown, a thickness d of the protruding portion 8 compared with a height h to the through opening 5 may extend from 10% to 30% of the height h in a vertical direction.

In general, independent of the embodiment shown, a width of the through opening 5, preferably of a trench, may be between 50 to 90 µm, preferably between 60 to 85 µm. A length of the opening in a planar direction may be less than 8mm, in particular less than 2 mm, preferably less than 1,5 mm.

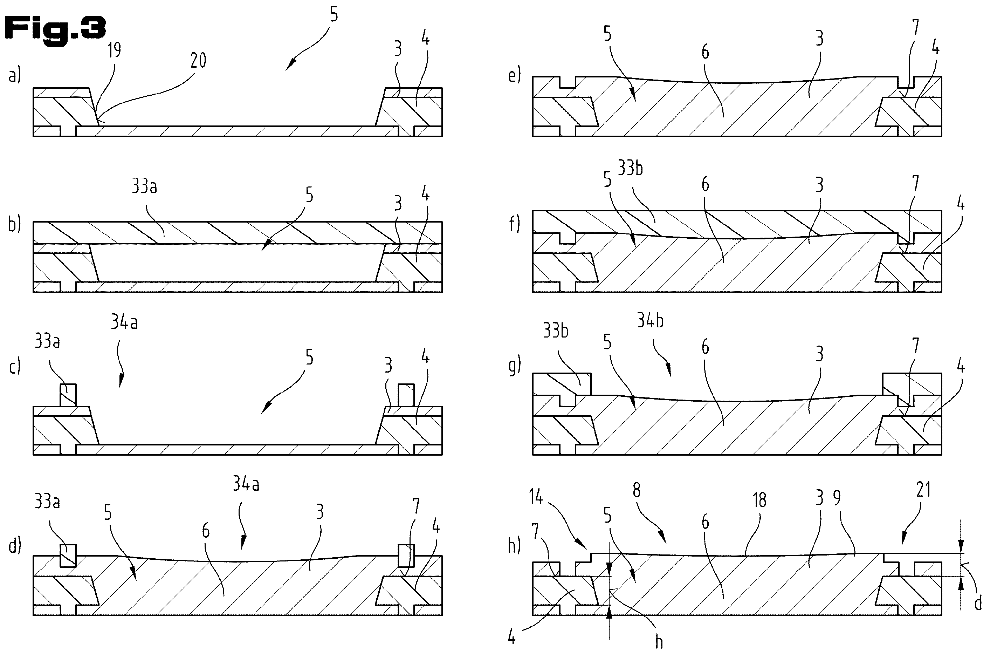

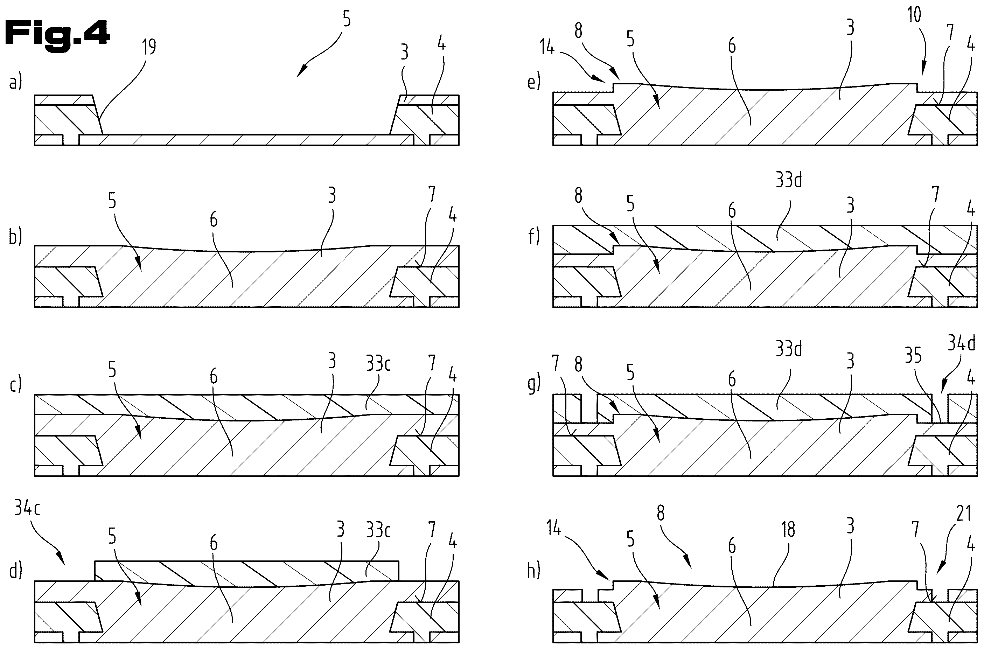

Fig. 3 and 4 show a method for manufacturing a component carrier 1 wherein equal reference numbers/component designations are used for equal parts as before in Fig.1 and 2. In order to avoid unnecessary repetitions, it is pointed to/reference is made to the detailed description in Fig. 1 and 2 preceding it.

The method comprises the steps of:
- providing a stack 2 comprising at least one insulating layer structure 4 and at least one conductive layer structure 3,
- forming at least one through opening 5 in the insulating layer structure 4;
- filling the through opening 5 with a conductive material 6 of the at least one electrically conductive layer structure 3;
wherein a protruding portion 8 is formed at the through opening 5, and wherein the protruding portion 8 protrudes from a surface of the conductive layer structure away from a first main surface 7 of said at least one insulating layer structure 4.

According to a preferred embodiment, the through opening 5 may be provided by forming a trench 19 in the insulating layer structure 4, which is indicated in the Figures 3 and 4.

Referring to the steps shown in Fig.3, an mSAP process flow may be used to form the trench.

Referring to Fig. 3a), at least one insulating layer structure 4 and at least one conductive layer structure 3 may be provided, wherein a through opening 5 may have been formed in the insulating layer structure 4, preferably by a laser. Alternatively, mechanical cutting may be used.

With respect to Fig. 3b) and c) a temporary layer 33a (e.g. dry film) may be formed at least partially on the at least one insulating layer structure 4 and at least one conductive layer structure 3, the temporary layer 33a will be removed (e.g. stripped) step by step in later process. For instance, according to Fig. 3c), the temporary layer 33a is partially removed so that a breakthrough/opening 34a of the temporary layer 33a is formed above the through opening 5, and a small portion of temporary layer 33a remained, small portion of temporary layer 33a is located adjacent to the through opening 5 and on a preformed conductive layer which on the first main surface 7 of insulting layer structure 5.

According to Fig. 3 d) the conductive material 6 of the at least one conductive layer of conductive layer structure 3 may be plated in the trench 19 and on the conductive layer (which has been provided on the first main surface 7 of insulting layer structure 4, e.g. a copper foil) of the conductive layer structure 3 of the intermediate product, in a breakthrough/opening 34a of the temporary layer 33a.

The through opening 5 can be filled with conductive material 6 during the plating step. Preferably, the conductive material 6 is in direct contact with the conductive layer below.

As mentioned before, a plurality of plating steps may be provided, one first plating step and at least one second plating step.

After filling the through opening 5, the temporary layer 33a may be partially or totally removed, for example by stripping. In other words, the small portion of temporary layer 33a is removed. According to Fig. 3 e) a small cavity/recess will be formed at the position of a small portion of temporary layer 33a. As it can be seen, a larger dimple may be formed at this stage.

According to Fig. 3f) and g) a further temporary layer 33b (e.g. dry film) may be provided on the intermediate product, preferably laminated, wherein at least one breakthrough/opening 34b may be provided in the temporary layer 33b in the area of the through opening 5. The breakthrough/opening 34b may be formed by exposure and developing of the temporary layer 33b, and then provide an additional conductive layer (by plating) into least one breakthrough/opening 34b, after that, the temporary layer 33b is partially or totally removed so that the step 14 can be formed (according to Fig. 3h). As it can be seen in Fig. 3 h), the protruding portion 8 may be formed by plating an additional layer 9 of conductive material 6 on the electrically conductive layer structure 3. Preferably an embodiment of the step 14 can be formed, as indicated.

Preferably, the protruding portion 8 may be formed by (flash) etching a portion of the at least one conductive layer structure 3 to limit the protruding portion 8. Meanwhile the etching step could expose the insulating material at the position of the (removed) small portion of the temporary layer 33a and/or the further temporary layer 33b, in such way that a further deeper cavity/recess can be formed.

The further deeper cavity/recess can be filled with insulting materials to serve as an intermediate connection path between two insulting layers in stack 2 to separates the protruding portion 8 from the remaining electrically conductive layer structure, thus a specific function can be realized, for instance isolated the whole stacked trench with other (active) conductive layer structure 3 to serve as an isolated thermal dissipation component.

The protruding portion 8 may also be provided by forming a step 14 in the conductive layer structure 3.

As it can be further seen, a (smaller) dimple 18 may be formed in the protruding portion 8, wherein the dimple 18 extends inside the protruding portion 8. It looks flat through the illustrated cross-section figures.

Referring to the series figures of Fig. 4, a subtractive process flow is indicated for trench formation.

According to a further possible embodiment, referring to Fig. 4a), at least one insulating layer structure 4 and at least one conductive layer structure 3 may be provided, wherein a through opening 5 may have been formed in the insulating layer structure 4. The through opening 5 preferably partially exposes the conductive layer structure 3. This step may be performed by laser drilling, for example.

According to Fig. 4 b) the conductive material 6 of the at least one conductive layer of the conductive layer structure 3 may be plated in the through opening 5 and on the surface of the conductive layer structure 3 of the intermediate product.

The through opening 5 can be filled with conductive material 6 during the plating step. Preferably, the conductive material 6 is in direct contact with the conductive layer below.

As it can be seen, a greater dimple may be formed at this stage, wherein the greater dimple may act as an intermediate dimple with respect to its depth compared of the dimple to be formed later.

After filling the through opening 5, a temporary layer 33c (e.g. dry film) may be provided on the intermediate product, as shown in Fig. 4 c).

The temporary layer 33c may be partially provided or partially removed, as it can be seen by the breakthrough/opening 34c in Fig. 4 d), wherein the temporary layer 33c may be present at least at the area of the through opening 5. A portion of the of the conductive layer structure 3 which is not covered by the temporary layer 33c may be removed at least partially. The removal of the conductive material of the portion may be carried out by etching.

According to Fig. 4 e), an upper surface of the conductive layer structure 3 can be partially removed in a vertical direction, wherein a thinner portion of the conductive layer structure 3 laterally besides the through opening 5 can be formed, so that the step 14 is initially formed. In other words, the protruding portion 8 may be formed by etching the portion of the at least one conductive layer structure 3 to limit the protruding portion 8, as it can be seen in Fig. 4 e), preferably flash etching. As it can be further seen, a thickness of the conductive layer structure may be reduced by carrying out the etching step.

Referring to Fig. 4 f) and g) a further temporary layer 33d (e.g. dry film) may be provided on the intermediate product, wherein at least one breakthrough/opening 34d may be formed in the further temporary layer 33d exposing a portion 35 of the conductive layer structure.

A further etching step may be performed on the intermediate product, wherein the exposed portion 35 of the conductive layer structure by said breakthrough 34d may be removed, preferably fully within a depth to the insulating layer structure.

As further indicated, the insulation layer structure 4 may be partially exposed.

With respect to Fig. 4h) the protruding portion 8 can be provided by forming the step 14 in the conductive layer structure 3.

The (smaller) dimple 18 may be formed by a plating step at the through opening 5. As mentioned before, the plating step in the through opening can result in a large dimple, mitigated by the plated portion forming the protruding portion, which can result in a smaller dimple.

Alternatively, no further plating steps may be provided at this stage.

As indicated in Fig. 3 and 4, the electrically conductive structure 3 may comprise a part 21 that forms the protruding portion 8 which may be disconnected from a remaining electrically conductive layer structure 3 (e.g. traces, pattern, pads) at the first main surface 7 of said at least one insulating layer structure 4.

Alternatively, the opening in the conductive layer structure that disconnects the part 21 may not be formed, so that there may be a connection between the respective portions of the conductive layer structure. For example, by not providing the breakthrough 34d in the temporary layer 33d.

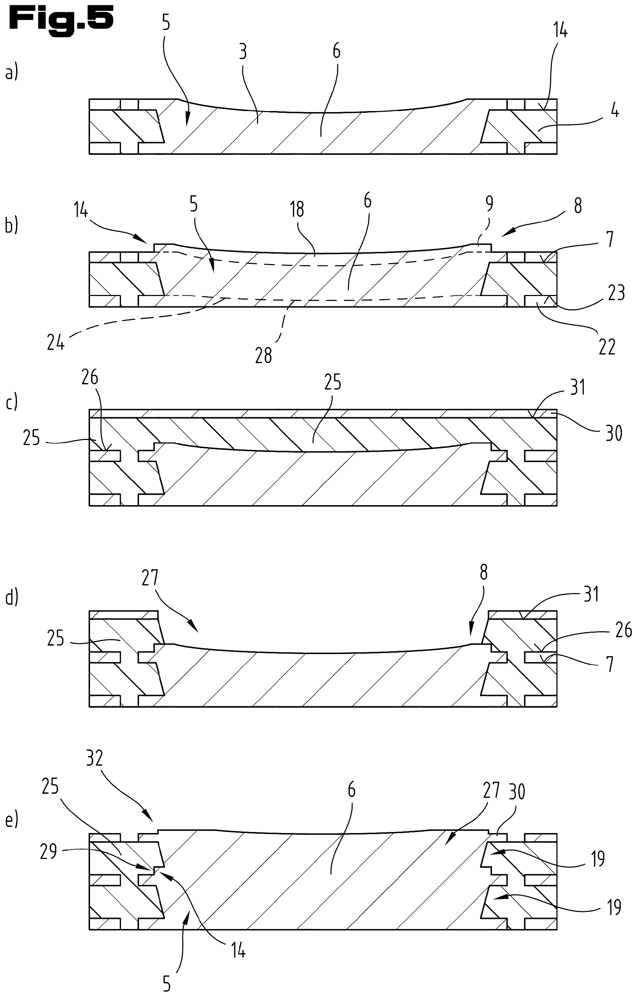

Fig. 5 shows a further possible embodiment of an intermediate product of a component carrier, wherein equal reference numbers/component designations are used for equal parts as before in Fig.1 to 4. In order to avoid unnecessary repetitions, it is pointed to/reference is made to the detailed description in Fig. 1 to 4 preceding it.

As it can be seen in Fig. 5 a) and b) an intermediate product may be provided. The intermediate product may be formed as described in Fig. 3 or Fig. 4.

The method of manufacturing a component carrier may also comprise a step of providing a second electrically conductive layer structure 22 on the opposed second main surface 23 of the insulating layer structure 4, wherein the conductive material 6 on the first main surface 7 of said at least one insulating layer structure 4 and in the through opening 5 may be connected to said second electrically conductive layer structure 22 to form a boundary connecting area 24.

Said boundary connecting area 24 may be formed in a concave shape in such way that a further dimple 28 may be provided in the second electrically conductive layer structure 22.

Independent from that, according to Fig. 5 c) a further insulating layer structure 25 may be provided on a planar surface 26 of the at least one conductive layer structure 3 and on the first main surface 7 of said at least one insulating layer structure 4, wherein a further through opening 27 may be formed in said further insulating layer structure 25 and wherein the further through opening 27 may be filled with a conductive material 6, according to Fig. 5 d)

As already mentioned, a plurality of trenches 19 (can be considered as a stacked trench) may be formed in a vertical direction with respect to each of the trenches 19.

Furthermore, at least one further electrically conductive layer structure 30 may be provided on a further main surface 31 of said further insulating layer structure 25, wherein a further protruding portion 32 may be formed at the further through opening 27 area protruding from a surface of the further conductive layer structure away from the further main surface 31 of said further insulating layer structure 25. The further main surface may preferably be orientated in the same direction as the first main surface, and preferably parallel to it.

The conductive material 6 filled in the further through opening 27 preferably may contact the protruding portion 8.

As shown each of the through opening 5 and at least the further through opening 27 may be formed by a trench 19, wherein the through opening 5 and at least the further through opening 27 may be filled by conductive material 6 in each step of providing the electrically conductive layer structure 3 and providing the further conductive layer structure.

At least one further step portion 29 may be formed at a lateral edge of the further insulating layer structure 25 and wherein the at least one step portion 29 may be complementary with the step 14 of the protruding portion 8.

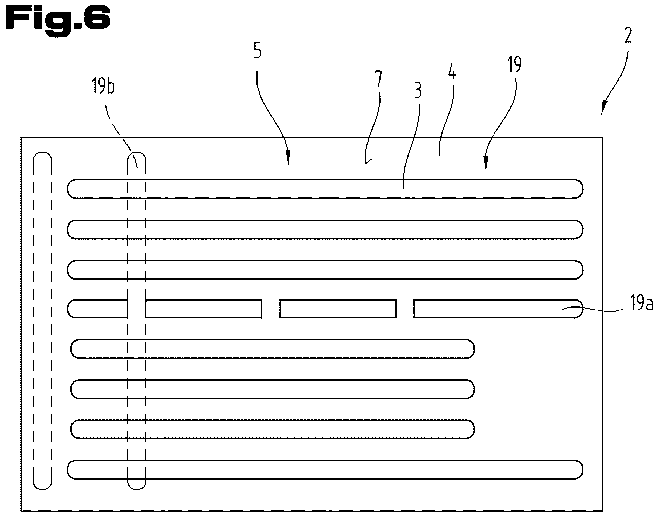

Fig. 6 shows a possible embodiment of a stack in a schematic top view, wherein equal reference numbers/component designations are used for equal parts as before in Fig.1 to 5. In order to avoid unnecessary repetitions, it is pointed to/reference is made to the detailed description in Fig. 1 to 5 preceding it.

For the sake of completeness, it should be said that the (stacked) trenches 19 shown in Fig. 6 may be provided preferably in the same plane of the stack 2, whereby (stacked) the trenches 19 shown may comprise examples of different, and possibly independent embodiments with respect to each other.

As shown in Fig. 6, a plurality of trenches 19 may be formed in a plane parallel to the first main surface 7 with respect to each of the trenches 19.

The plurality of trenches 19 may be arranged parallel to each other,

As further indicated, independent of the embodiment shown, a trench 19a may be formed discontinuously. Other distribution of the trenches may also be possible.

At least two trenches may also be intersected with each other. As also indicated by dashed lines, at least one trench 19b may be arranged perpendicular to an extension of at least one further trench.

It should be noted that also further arrangements, as well as different geometries with respect to the trenches may be provided, for example, transverse to each other, but not exactly perpendicular.

**List of reference**

| | | | |
|---|---|---|---|
| 1 | component carrier | 30 | further electrically conductive layer structure |
| 2 | stack | | |
| 3 | conductive layer structure | 31 | further main surface |
| 4 | insulating layer structure | 32 | further protruding portion |
| 5 | through opening | 33 | temporary layer |
| 6 | conductive material | 34 | breakthrough |
| 7 | first main surface | 35 | portion |
| 8 | protruding portion | 36 | first vertical center axis |
| 9 | additional layer | 37 | second vertical center axis |
| 10 | etched portion | | |
| 11 | core area | d | thickness |
| 12 | lateral portion | h | height |
| 13 | lateral surface | | |
| 14 | step | | |
| 15 | conductive layer | | |
| 16 | side | | |
| 17 | offset | | |
| 18 | dimple | | |
| 19 | trench | | |
| 20 | sidewall | | |
| 21 | part | | |
| 22 | second electrically conductive layer structure | | |
| 23 | second main surface | | |
| 24 | boundary connecting area | | |
| 25 | further insulating layer structure | | |
| 26 | planar surface | | |
| 27 | further through opening | | |
| 28 | further dimple | | |
| 29 | step portion | | |

## Claims

1. A component carrier (1), comprising
- a stack (2) comprising at least one conductive layer structure (3) and at least one insulating layer structure (4), wherein the at least one insulating layer structure (4) comprises a through opening (5) that is filled with a conductive material (6) of the at least one electrically conductive layer structure (3), wherein said at least one electrically conductive layer structure (3) is in contact with a first main surface (7) of said at least one insulating layer structure (4), and wherein the at least one electrically conductive layer structure (3) comprises a protruding portion (8) at the through opening (5) that is protruding from a surface of the at least one electrically conductive layer structure (3), away from the first main surface (7) of said at least one insulating layer structure (4).

2. A component carrier (1) according to claim 1, wherein the protruding portion (8) comprises an additional layer (9) of conductive material (6) on the electrically conductive layer structure (3).

3. A component carrier (1) according to claim 1 or 2, wherein the amount of conductive layers (15) composing the at least one electrically conductive layer structure (3) at the first main surface (7) of said at least one insulating layer structure (4) is lower than the amount of conductive layers (15) of the at least one electrically conductive layer structure (3) at the protruding portion (8).

4. A component carrier (1) according to one of the claims 1 to 3, wherein the protruding portion (8) is delimited by an etched portion (10) of the at least one conductive layer structure (3).

5. A component carrier (1) according to one of the claims 1 to 4, wherein the conductive material (6) filling the through opening (5) has a grain size in its core area (11) higher than a grain size of a respective lateral portion (12) of the conductive material (6) filling the through opening (5).

6. A component carrier (1) according to one of the claims 1 to 5, wherein a lateral portion (12) of the conductive layer structure (3) comprises at least one layer in contact with a lateral surface (13) of the through opening (5).

7. A component carrier (1) according to claim 5 or 6, wherein the lateral portion (12) of the conductive layer structure (3) comprises at least one layer that defines the protruding portion (8).

8. A component carrier (1) according to one of the claims 1 to 7, wherein at least one step (14) is formed by the protruding portion (8), in particular, the step (14) is formed by a circumferential step that defines the protruding portion (8) and/or an irregular formed side (16a) of the conductive layer structure (3) defines the step (14) and/or the step (14) comprises an inclined side (16b) with respect to the first main surface (7).

9. A component carrier (1) according to one of the claims 1 to 8, wherein the protruding portion (8) at least partially overlaps the through opening (5) profile in a plane direction , in particular completely.

10. A component carrier (1) according to one of the claims 1 to 9, wherein the protruding portion (8) is formed in an offset (17) from the through opening (5) in a planar view.

11. A component carrier (1) according to one of the claims 1 to 10, wherein the protruding portion (8) comprises a dimple (18), wherein the dimple (18) extends inside said protruding portion (8), in particular, the dimple (18) is formed planarly within an extension of the protruding portion (8) and/or the dimple (18) is formed planarly inside an extension of the through opening (5).

12. A component carrier (1) according to one of the claims 1 to 11, wherein the through opening (5) is formed by a trench (19), in particular the trench (19) comprises a tapering sidewall (20) and/or the trench (19) is formed planarly in an elongated direction with respect to the first main sur-face (7).

13. A component carrier (1) according to one of the claims 1 to 12, wherein a plurality of trenches (19) is formed in a plane parallel to the first main surface (7) with respect to each of the trenches (19).

14. A component carrier (1) according to one of the claims 1 to 13, wherein a part (21) of the electrically conductive structure (3) that forms the protruding portion (8) is disconnected from a remaining electrically conductive layer structure (3) at the first main surface (7) of said at least one insulating layer structure (4), in particular the conductive material (6) filling the through opening (5) has a grain size in its core area (11) higher than a grain size of the remaining electrically conductive layer structure (3) and/or the part (21) of the electrically conductive structure at the protruding portion (8) that is disconnected from the remaining electrically conductive layer structure (3) is provided for thermal dissipation in the stack (2) and/or a density of the conductive material (6) in the volume of the component carrier (1) comprising said part (21) of the electrically conductive structure (3) at the protruding portion (8) is higher than the density of the conductive material in the volume of the component carrier (1) comprising the remaining electrically conductive structure (3).

15. A method for manufacturing a component carrier (1) according to one of the preceding claims, comprising the steps of:
- providing a stack (2) comprising at least one insulating layer structure (4) and at least one conductive layer structure (3),
- forming at least one through opening (5) in the insulating layer structure (4);
- filling the through opening (5) with a conductive material (6) of the at least one electrically conductive layer structure (3);
wherein a protruding portion (8) is formed at the through opening (5), and wherein the protruding portion (8) protrudes from a surface of the conductive layer structure away from a first main surface (7) of said at least one insulating layer structure (4).
